Europäisches Patentamt

European Patent Office

Office européen des brevets

(19)

(11) Veröffentlichungsnummer : **0 045 074**
**B1**

(12) **EUROPÄISCHE PATENTSCHRIFT**

(45) Veröffentlichungstag der Patentschrift :
09.01.85

(51) Int. Cl.⁴ : **G 01 R 27/20**

(21) Anmeldenummer : **81105880.9**

(22) Anmeldetag : **24.07.81**

(54) **Vorrichtung zur Messung des Übergangswiderstandes galvanisch aufgetragener Oberflächenschichten.**

(30) Priorität : **28.07.80 DE 3028535**

(43) Veröffentlichungstag der Anmeldung :
**03.02.82 Patentblatt 82/05**

(45) Bekanntmachung des Hinweises auf die Patenterteilung : **09.01.85 Patentblatt 85/02**

(84) Benannte Vertragsstaaten :
**DE GB NL**

(56) Entgegenhaltungen :
**JAPANESE JOURNAL OF APPLIED PHYSICS, Band 13, Nr. 12, Dezember 1974, Seiten 1996-2003 Tokyo, JP. O. MICHIKAMI: "Study on the constriction resistance of electric contact"**
**JOURNAL OF PHYSICS E SCIENTIFIC INSTRUMENTS, Band 10, Nr. 4, April 1977, Seiten 330-332 London, G.B. E.T. WALLACH et al.: "A test facility for the measurement of very small resistances"**
**ELECTRONICS, Band 48, Nr. 22, 30. Oktober 1975, Seiten 105-107 New York, U.S.A. S. GARTE: "What designers need to know about low-voltage contacts"**

(73) Patentinhaber : **Siemens Aktiengesellschaft Berlin und München Wittelsbacherplatz 2 D-8000 München 2 (DE)**

(72) Erfinder : **Boone, Didier**
**Nieuwstrasse 7**
**B-8042 Oostkamp (BE)**
Erfinder : **Cousin, Rolf, Ing.grad.**
**Hazelare 4**
**B-8021 Loppem (BE)**

Jouve, 18, rue St-Denis, 75001 Paris, France

## Beschreibung

Die Erfindung bezieht sich auf eine Vorrichtung entsprechend dem Oberbegriff des Anspruches 1.

Eine solche Vorrichtung ist beispielsweise aus « Japanese Journal of applied Physics », Band 13, Nr. 12, Dez. '74, Seiten 1996 bis 2003, insbesondere Fig. 7 und zugehörigem Text bekannt. Diese Vorrichtung verwendet zwei kreuzweise angeordnete Drahtstücke, die mit den entsprechenden galvanisch aufgetragenen Oberflächenschichten überzogen sind. Mit Hilfe eines Elektromagneten werden die an eine Spannungsquelle angeschlossenen Drahtstücke definiert gegeneinander gepreßt und dann der zwischen den Drahtstücken auftretende Spannungsabfall sowie der über die Drahtstücke fließende Strom gemessen. Aus diesen Daten kann dann der Übergangswiderstand ermittelt werden.

Die Übergangswiderstände zwischen galvanisch beschichteten Oberflächen sind jedoch relativ sehr klein und zudem starken Schwankungen unterworfen, so daß auf diese Weise nur mit relativ großem Aufwand brauchbare Ergebnisse erzielt werden können.

Aus « Journal of Physics E scientific Instruments », Band 10, Nr. 4, April '77, Seiten 330 bis 332, ist es im Zusammenhang mit der Messung sehr kleiner Widerstände bekannt, mehrere jeweils kleine Widerstandswerte repräsentierende Elemente in Serie zu schalten, um damit zu meßbaren Werten zu gelangen.

Aufgabe vorliegender Erfindung ist es nun, eine Vorrichtung der eingangs genannten Art zu schaffen, mit der auf einfache Weise und mit praktisch beliebiger Genauigkeit der Übergangswiderstand zwischen galvanisch beschichteten Oberflächen gemessen werden kann.

Erfindungsgemäß ergibt sich die Lösung dieser Aufgabe durch die Ausbildung einer solchen Vorrichtung entsprechend den kennzeichnenden Merkmalen des Anspruches 1.

Eine weitere Ausgestaltung der Erfindung ergibt sich aus dem Merkmal des Anspruches 2.

Nachfolgend wird anhand von zwei Figuren ein Ausführungsbeispiel der Erfindung noch näher erläutert. Dabei zeigen :

Figur 1 eine perspektivische Ansicht der Vorrichtung und

Figur 2 eine Ansicht von oben auf die Vorrichtung.

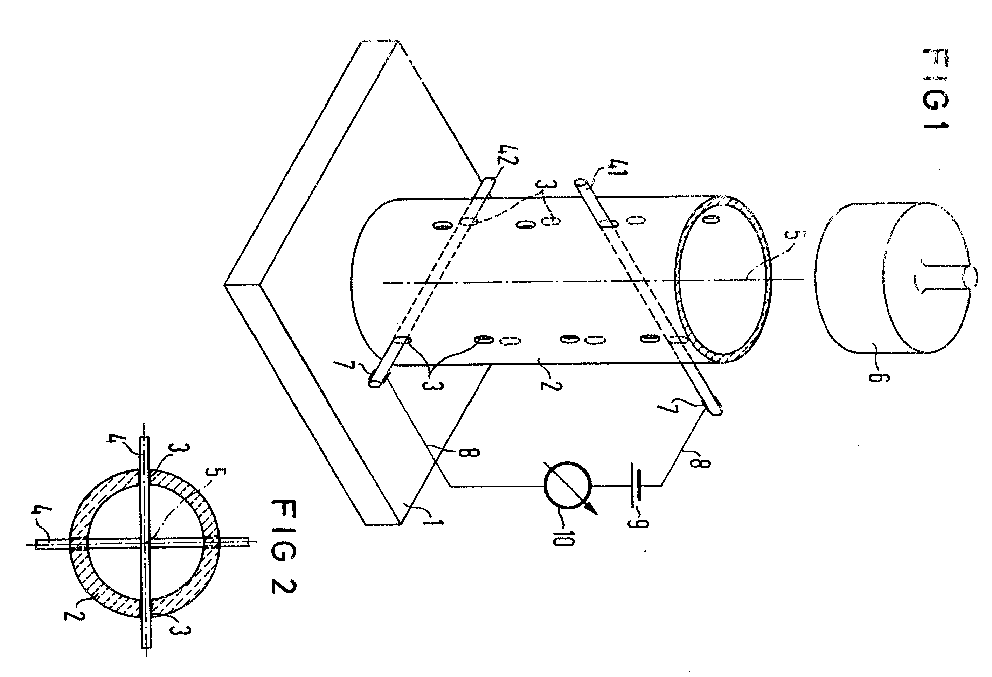

Auf einer Grundplatte 1 aus Isoliermaterial ist ein hohlzylindrischer Körper 2 aus Isolierstoff, insbesondere aus Keramik, mit rechtwinklig zur Platte 1 gerichteter Achse 5 befestigt. Dieser Körper 2 weist in Achsrichtung über seinen Umfang verteilt, paarweise korrespondierende Ausnehmungen 3 zum Durchstecken von Drahtstücken 4 auf, die in Achsrichtung oval bis schlitzförmig ausgebildet sind. Wie insbesondere Fig. 2 zeigt, sind die Ausnehmungen 3 für die Drahtstücke 4 in Umfangsrichtung um 90° gegeneinander versetzt angeordnet. Außerdem sind die Mittelpunkte jeweils um 90° gegeneinander versetzter in Achsrichtung aufeinanderfolgender Paare von Ausnehmungen um die Stärke der Drahtstücke 4 in Richtung der Achse 5 gegeneinander versetzt.

Werden in sämtliche korrespondierende Paare von Ausnehmungen 3 Drahtstücke 4 gesteckt, so sind dadurch die Drahtstücke 4 kreuzweise übereinander geschichtet, wobei sich die Drahtstücke spannungsfrei berühren und die Berührungspunkte der Drahtstücke 4 sich in der Achse 5 des hohlzylindrischen Körpers 2 befinden. Der unterste Draht 42 ist in seiner Mitte abgestützt um ein Durchbiegen der Drähte zu verhindern. Die im Körper 2 steckenden Drahtstücke 4 werden mit Hilfe eines kolbenartigen Gewichtes 6 belastet, das von oben her in den Körper 2 eingeführt wird. Der von dem Gewicht ausgeübte Druck ist hierbei so groß zu wählen, daß ein guter Kontakt zwischen den Drahtstücken 4 entsteht, aber noch keine Deformation der Drahtstücke 4 an den Berührungspunkten erfolgt. Dabei ist vorteilhaft, die Größe des Druckes so zu wählen, daß eine weitere Steigerung nur noch eine vernachlässigbare Veränderung des Gesamtwiderstandes ergibt. Werden nun mit Hilfe von Klemmen 7 Leitungen 8 an dem obersten und untersten Drahtstück (41 bzw. 42) angeschlossen, die über ein Meß-Instrument 10 mit einer Spannungsquelle 9 verbunden sind, so kann der Gesamtwiderstand der Anordnung gemessen werden. Dieser setzt sich im wesentlichen aus dem Leitungswiderstand von zweimal der halben Drahtstücklänge sowie aus dem Übergangswiderstand von sämtlichen n Berührungspunkten der Drahtstücke zusammen. Demgegenüber ist der Widerstand, der sich aus der Parallelschaltung des Widerstandes des Grundmaterials der Drahtstücke und des Oberflächenwiderstandes der galvanischen Beschichtung der Drahtstücke zusammensetzt, vernachlässigbar klein.

Aus dem Gesamtwiderstand kann der Einzel-Übergangswiderstand zwischen zwei galvanischen Schichten leicht berechnet werden, da der Leitungswiderstand bekannt ist. Wird dieser vom Gesamtwiderstand abgezogen, erhält man den Übergangswiderstand durch Dividieren des erhaltenen Wertes durch die Anzahl n der Kontaktpunkte zwischen jeweils zwei Drahtstücken 4.

Der Übergangswiderstand zwischen den Leitungen 8 und den mit diesen verbundenen Drahtstücken 41, 42 kann durch geeignete Anschlußmethoden eliminiert werden. Dadurch, daß eine Vielzahl von Kontaktpunkten vorgesehen wird, kann mit einer relativ einfachen Meßmethode der Übergangswiderstand ausreichend genau ermittelt werden. Diese Genauigkeit kann im übrigen durch eine Erhöhung der Anzahl der verwendeten Drahtstücke so hoch, wie gewünscht, gewält werden. Ferner besteht die Möglichkeit, die Messung bei den unterschiedlichsten Meßbedingungen auszuführen, so daß Einflüße wie z. B. von Temperatur, vom Aufbau der galvanischen Schicht, von Zeit und Luftfeuchtigkeit usw. unabhängig voneinander untersucht werden können.

Bezugszeichenliste

1 Grundplatte
2 hohlzylindrischer Körper
3 Ausnehmungen in 2
4 Drahtstücke
41 oberstes Drahtstück
42 unterstes Drahtstück
5 Achse von 2
6 kolbenförmiges Gewicht
7 Klemmen
8 Leitungen
9 Spannungsquelle
10 Meßgerät

**Ansprüche**

1. Vorrichtung zur Messung des Übergangswiderstandes zwischen galvanisch aufgetragenen Oberflächenschichten, bei der mit einer derartigen galvanischen Schicht versehene Drahtstücke (4) kreuzweise übereinander geschichtet und mit einem definierten Druck aneinandergepreßt sind und bei der dann zwischen dem obersten und untersten Drahtstück (41 bzw. 42) der auftretende Widerstand gemessen wird, dadurch gekennzeichnet, daß die Drahtstücke (4) durch paarweise korrespondierende Ausnehmungen (3) eines hohlzylindrischen Körpers (2) aus Isolierstoff gesteckt sind, daß die Ausnehmungen (3) längs der Körpers (2) und über seinen Umfang hinweg zueinander derart versetzt vorgesehen sind, daß die Drahtstücke jeweils durch die Achse (5) des hohlzylindrischen Körpers (2) gehen und kreuzweise übereinander liegen, und daß schließlich die im Körper (2) steckenden Drahtstücke (4) mit Hilfe eines kolbenartigen Gewichtes (6) belastet sind, das von oben her in den Körper (2) eingeführt ist.

2. Vorrichtung nach Anspruch 1, dadurch gekennzeichnet, daß die Ausnehmungen (3) in Achsrichtung des Körpers (2) oval bis schlitzförmig ausgebildet sind.

**Claims**

1. Apparatus for measuring the contact resistance between electrodeposited surface layers, in which pieces of wire (4), which are provided with such an electrodeposited layer, are stacked crosswise one above another and are pressed against one another with a defined pressure, and in which the resistance occurring between the uppermost and the lowermost wire pieces (41 and 42) is then measured, characterized in that the wire pieces (4) are passed through apertures (3), which correspond to one another in pairs, in a hollow cylindrical body (2) made of an insulating material ; that along the body (2) and around its periphery, the apertures (3) are arranged to be staggered with respect to one another in such manner that the wire pieces respectively run through the axis (5) of the hollow-cylindrical body (2) and are arranged transversely above one another, and that the wire pieces (4) which are fitted into the body (2) are finally loaded with the aid of a piston-like weight (6) which is introduced into the body (2) from the top.

2. Apparatus as claimed in Claim 1, characterised in that the apertures (3) are shaped so as to be oval to slot-shaped in the axial direction of the body (2).

**Revendications**

1. Dispositif de mesure de la résistance de contact entre des couches superficielles déposées par voie galvanique, dans lequel des pièces en forme de fils métalliques (4) et munies d'une telle couche par voie galvanique se croisent en étant l'une au-dessus de l'autre et sont pressées l'une vers l'autre avec une pression définie et dans lequel ensuite la résistance électrique se produisant entre la pièce supérieure en forme de fil métallique et la pièce inférieure en forme de fil métallique (41 et 42) est mesurée, caractérisé en ce que les pièces en forme de fils métalliques (4) sont enfilées dans des perçages se correspondant par paire d'un corps (2) en matière isolante et ayant la forme d'un cylindre creux, en ce que les perçages (3) sont décalés les uns par rapport aux autres le long du corps (2) et sur son pourtour de manière à ce que les pièces en forme de fils métalliques passent par l'axe (5) du corps (2) en forme de cylindre creux et se croisent en étant l'une au-dessus de l'autre, et en ce qu'enfin les pièces en forme de fils métalliques (4) enfilées dans le corps (2) sont chargées à l'aide d'une masselotte (6) de type à piston qui est introduite dans le corps (2) par le haut.

2. Dispositif suivant la revendication 1, caractérisé en ce que les perçages (3) ont une forme allant de la forme en oval à la forme en fente dans la direction de l'axe du corps (2).

0 045 074

FIG 1

FIG 2

1